Europäisches Patentamt

European Patent Office

Office européen des brevets

(11) Publication number: 0 603 913 A1

# EUROPEAN PATENT APPLICATION

(21) Application number: 93120890.4

(51) Int. Cl.5: G21B 1/00, H05H 1/12

(22) Date of filing: 24.12.93

(30) Priority: 25.12.92 JP 357837/92
26.05.93 JP 145467/93

(43) Date of publication of application:
29.06.94 Bulletin 94/26

(84) Designated Contracting States:
DE FR GB

(71) Applicant: UNINET CO., LTD.
3-4-16 Yahata-cho,
Musashimo
Tokyo(JP)
Applicant: MITSUBISHI JUKOGYO KABUSHIKI
KAISHA
5-1, Marunouchi 2-chome
Chiyoda-ku
Tokyo 100(JP)
Applicant: Toyo Tanso Co., Ltd.
No. 7-12, Takeshima 5-chome
Nishi Yodogawa-ku

Osaka-shi Osaka(JP)

(72) Inventor: Yamaguchi, Sataro
18-17 Kanokoden
Chikusa-ku
Nagoya, Aichi(JP)
Inventor: Motojima, Osamu
Carnegie Tajimi 1001
2-58-1 Hirokoji
Tajimi, Gifu(JP)
Inventor: Sagara, Akio Omori-higashi
Jutaku 16-301
1-1101 Motogo
Moriyama, Nagoya, Aichi(JP)

(74) Representative: DIEHL GLAESER HILTL &
PARTNER
Flüggenstrasse 13
D-80639 München (DE)

(54) Thermoelectric power generating device.

(57) A divertor device comprises a divertor plate (100), a thermocouple (201,202) contacting the divertor plate (100) and a cooling pipe (204) to provide temperature difference for generating power. For baking current is caused to flow through a thermocouple (201,202) by an external power source and a high-temperature fluid is caused to flow through the cooling pipe (204). A divertor device including a divertor plate (or a wall) exposed to plasma, a power generating member mounted on the divertor plate (or wall) and electrodes (203,205) mounted in a direction, perpendicular to both directions of temperature gradient and magnetic field, for generating power under the Nernst effect. Electric power is generated directly from a divertor plate (or wall) employed for experimental nuclear fusion device or nuclear fusion reactor, also achieving heat removal and efficient baking.

EP 0 603 913 A1

(200)

HIGH TEMPERATURE SIDE

(100)

(201)

(202)

(203)

(204)

(204)

(205)

(207)

ELECTRICAL OUTPUT

LOW TEMPERATURE SIDE

FIG. 1

This invention relates to a power generating apparatus employing a wall exposed to a plasma, such as a divertor plate or a first wall employed in a nuclear fusion reactor or an experimental nuclear fusion device. Particularly it relates to thermoelectric power generation or power generation based on the Nernst effect. More particularly, the former relates to a divertor device having a thermocouple mounted on the divertor plate for generating electric power based on a difference in temperature on the divertor plate.

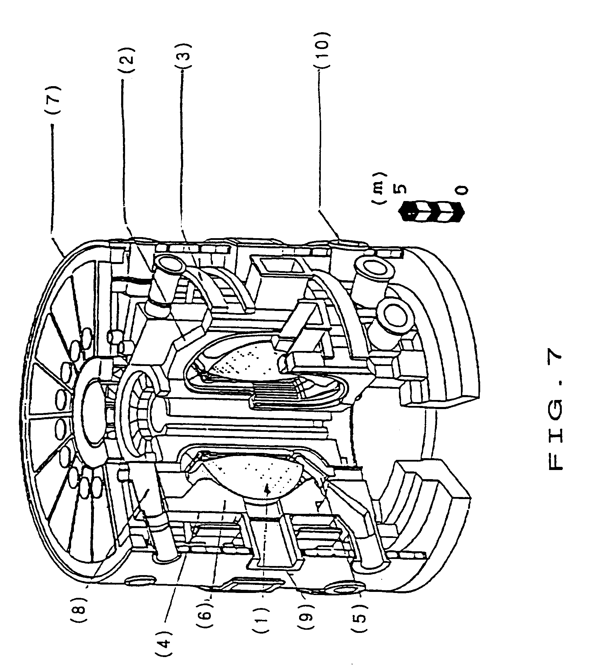

The conventional technique is explained referring to Figs. 7, 8 and 9.

Fig. 7 shows, in cross-section, an experimental nuclear fusion reactor, which is now being schemed under the appellation of ITER (International Thermonuclear Experimental Reactor). This drawing has been taken from the Journal of Japan Society of Atomic Power entitled "Conceptual Design Activity and Engineering R & D in ITER" by Takatsu et al, August 1991, p. 738.

The reactor is a plasma confinement device of the type known as TOKAMAK, which is a large-sized experimental device on which researches and development are being conducted under the international cooperation mainly by Japan, USA, Europe and Russia,

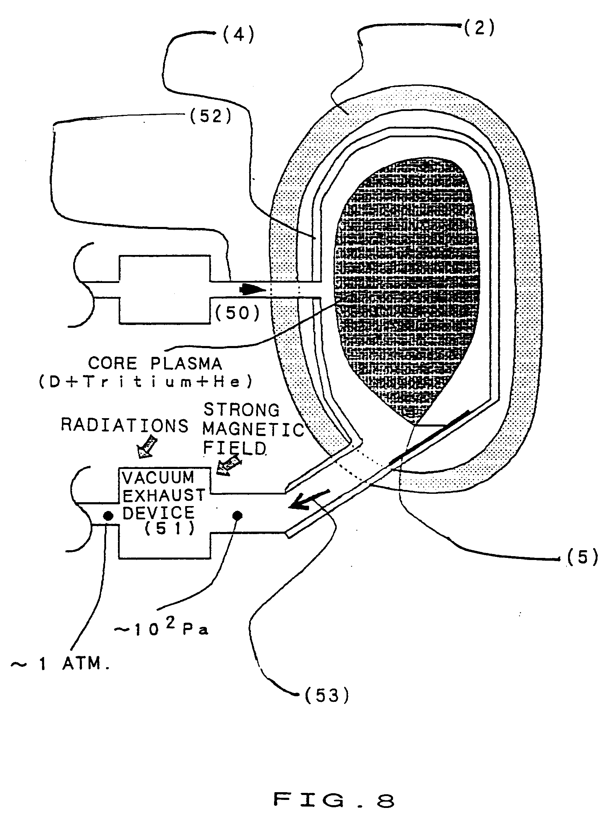

Fig. 8 is a schematic view of a fusion reactor based on the description on page 47 of a publication "Towards Fusion Reactor-Current Status in R & D of Nuclear Fusion 1992-" issued by Japan Atomic Energy Research Institute in 1992.

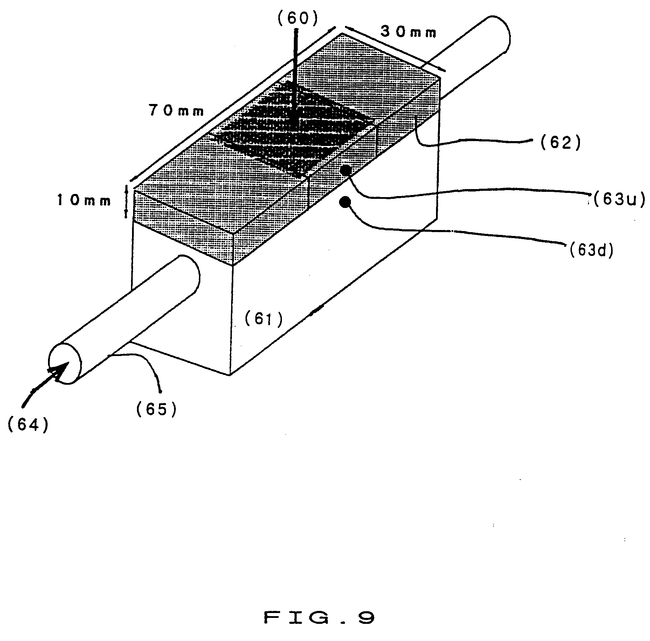

Fig. 9 is a shematic view showing the constitution of a divertor plate which is based on the description on page 77 of an Extended Abstract to 9th Autumn Meeting of Society of Plasma and Nuclear Fusion held on October 29 to 31, 1992, in Aoba Memorial Hall of Tohoku University. The prior art technology is hereinafter explained by referring to these drawings. In Fig. 7, a plasma 1 is within a vacuum vessel 4, and a divertor 5, also referred to as a divertor plate, is mounted below a plasma within the vacuum vessel 4. A blanket 6 is mounted between the vacuum vessel 4 and the plasma 1. The plasma is confined by a magnetic field by a toroidal coil 2, a magnetic field by a poloidal coil 3 and plasma current. An exhaust duct 10 is connected to a vacuum pump, not shown, for evacuating the inside of the vacuum vessel 4.

A cryostat 7 is used for heat insulation in consideration that a superconducting coil is employed. An upper port 8 and a horizontal port 9 are used for diagnosing and heating the plasma 1.

In Fig. 8, deuterium and tritium, as fuels, are introduced into the plasma 1 via a fuel injection device 50. Nuclear reaction occurs in the plasma to produce energy. Part of the plasma is impinged on a divertor plate 5 and neutralized, while helium, deuterium and tritium 53 are exhausted as ashes out of the vacuum vessel 4 by a vacuum exhaust device 51.

Fig. 9 is a partial enlarged view showing a part of the divertor plate employed for developing the divertor plate. An electron beam 60 is employed for simulating a heat flow from the plasma 1.

Referring to Fig. 9, the divertor plate has its surface formed by a carbon member 62. A copper member 61 is joined to the divertor plate 62. Thermometers 63u, 63d are also joined to the divertor plate for temperature measurement. For heat removal a pipe 65 for transporting water 64 therein is provided through the copper member 61.

The operating principle is hereinafter explained.

For confining the high-temperature plasma, it is necessary for the plasma not to be impinged directly on the wall using the effect of a magnetic field. It is also necessary to provide some boundary for setting the plasma size. The current practice adopted generally is to use the magnetic field configuration in order to confine the plasma and control the plasma size. Such magnetic field configuration is referred to as a divertor configuration.

Since the time the divertor configuration has been found, significant improvement in plasma confinement has been achieved.

However, with such magnetic field configuration, it is not possible to eliminate the interaction between the plasma and the wall completely, such that the plasma flows out at a specified portion of the magnetic field configuration of the plasma.

It is therefore necessary to provide a heat-resistant wall which is resistant to the high-temperature plasma at plasma flowing positions. Such wall is the divertor plate. The role of the divertor plate is to protect the vacuum vessel wall against the high temperature of the plasma and to neutralize the plasma particles simultaneously.

As the experimental nuclear fusion device is increased in size, and plasma discharge time is prolonged, the divertor plate is exposed to a high heat load which amounts to approximately 10 MW/m$^2$ according to a current design value. Thus selection of a proper material for the divertor plate is thought to be crucial.

For diminishing effects of impurities on the plasma, the divertor plate has its surface covered with a carbon member. Besides, for efficient heat removal, the back surface of the divertor plate is covered with a copper member and water is circulated through a cooling pipe system for cooling the copper member.

Besides, for improving heat transfer, the copper member is reduced in thickness. For this reason, the current practice in general is to lay a cooling pipe oven within the inside of the vacuum vessel.

Besides, the above-described respective members, exposed to the nuclear reacting plasma, need to be formed of a material which is strong against radiation.

According to the views of the present invention, following problems are found in the related art.

The conventional divertor plate, playing the above role, is exposed to a high thermal load and fast neutrons, so that it suffers from a number of inconveniences and technical problems (1) to (3) recited hereinbelow. Numerous researches and investigations are proceeding briskly for overcoming these inconveniences and technical problems.

(1) Efficient Heat Removal in Consideration of High Thermal Load

Since the divertor plate is exposed to a high thermal load of 10 MW/m$^2$, the divertor plate material undergoes deformation or deterioration in use of prolonged operation. Thus it is desirable to remove heat consistently from the divertor plate. Furthermore, the distance between the plasma and a cooling pipe is to be reduced, so that the cooling pipe needs to be laid even in the inside of a vacuum vessel. However, this is not technically desirable for the vacuum vessel employed for plasma confinement.

(2) Baking of Divertor Plate

Currently, baking of the divertor plate is a time-consuming operation. This is due to the fact that a large quantity of gases is adsorbed in the carbon member employed as a surface material for the divertor plate. It is crucial to shorten the baking time.

(3) Improvement in Efficiency of Divertor Device

A large quantity of electric power is consumed for removing the heat intruded into the divertor plate. Such power is consumed only for discharging the heat and leads to lowering the overall energy efficiency of the nuclear fusion reactor. Hence a demand is raised for improving the efficiency of the divertor device.

Besides, a first wall is a wall facing the plasma, similarly to the divertor plate. Although high density plasma particles do not flow onto the first wall, as they do onto the divertor, the radiation heat from the plasma flows on the first wall. A mean heat load of the first wall is on the order of about one-hundredth of that of the divertor plate. A neutron flux in an amount of not less than one-hundredth flows on and through the first wall. A cooling structure is required for the first wall.

It is therefore an object of the present invention to overcome the above-mentioned drawbacks and to provide a divertor device, or generally wall arrangement, in which thermal energy from a plasma may be transformed into an electrical energy and taken out directly from a divertor plate and in which efficiant heat removal may be achieved efficiently.

This object is solved by the divertor device and thermoelectric power generating device of independent claims 1, 8, 13, 19, 20 and 21, and by a method for generating electric power and baking a wall to be exposed to a plasma of independent claims 22, 25 and 29. Further advantageous features, aspects and details of the invention are evident from the dependent claims, the description and the drawings.

The claims are intended to be understood as a first non-limiting approach of defining the invention in general terms.

It is another aspect of the present invention to provide a divertor device, or generally wall arrangement, in which heat may be transmitted efficiently to a surface material of the divertor plate (or generally wall plate) during baking.

According to a further aspect the present invention to provide a divertor device in which electrical power generation is achieved by taking advantage of an entirely new principle which has hetherto been not utilized for power generation.

According to a specific aspect the present invention to provide a thermoelectric power generating system in which thermal energy from plasma radiation applied to the first wall facing the plasma, is directly transformed into and recovered as electrical energy, and in which heat removal may be achieved efficiently.

It is another aspect of the present invention to provide a power generating system in which electrical power, is generated by taking advantage of an entirely new effect and principle which have hetherto been not utilized for power generation.

It is a further aspect of the present invention to provide an improved and novel baking system or method.

For generating electric power, a thermocouple is disposed in association with a wall to be exposed to a plasma, and electric power is generated based on a difference in temperature caused by the wall. This can be named thermoelectric power generation. A heat pipe may be disposed in association with the thermocouple to promote heat transfer. A cooling pipe system is provided in association with the thermocouple so as to enhance the temperature difference.

Baking is carried out by supplying current to the thermocouple from an external power source to produce heat. To aid the baking, a high temperature medium is supplied to the cooling pipe during a baking step.

As alternative method of generating power utilizing the energy present at the wall of the nuclear fusion reactor or the expermental device provides following solutions.

The Nernst effect is utilized to produce a potential difference in a member for generating electric power (usually metal and/or semiconductor, namely electron conductive material) disposed along a direction which is substantially perpendicular to two directions of magnetic field and temperature gradient (preferably, the latter two directions being also perpendicular to each other). The potential difference caused by the Nernst effect can be taken out via electrodes disposed along the direction perpendicular the latter two directions. The Nernst effect-power generation may be utilized in combination with the thermocouple power generation.

Particularly, the present invention provides a divertor device for generating electric power comprising a divertor plate employed in a nuclear fusion experimental device or a nuclear fusion reactor, and a thermocouple disposed in contact with the divertor plate, wherein the electrical power is generated based on a difference in temperature on the divertor plate.

The present invention also provides a divertor device wherein a member for generating the electric power comprises thermocouple(s) of metal and/or semiconductor.

The present invention also provides a divertor device wherein a heat pipe is built in the member for generating electric power based on the difference in temperature.

The present invention also provides a divertor device wherein thermocouples are connected in series or in parallel to a plurality of the divertor plates.

The present invention also provides a divertor device wherein electric current is supplied to the thermocouple from an external power source connected to the thermocouple.

The present invention also provides a divertor device wherein a high temperature fluid is caused to flow in a cooling pipe for baking the divertor plate and electric current is supplied to the thermocouple from an external power source for controlling surface temperature of the divertor plate.

The present invention provides, in its second aspect, a divertor device comprising:

a divertor plate employed in an experimental nuclear fusion device or a nuclear fusion reactor,

a member for generating electric power,

an insulating member,

a cooling member,

all of which are mounted on the divertor plate, and

at least a pair of electrodes mounted on the member along a direction which is substantially perpendicular to both directions of a temperature gradient and a magnetic field, for generating the electric power,

wherein the electric power is generated under the Nernst affect based on the temperature gradient and the magnetic field. Preferably the both directions of the temperature gradient and the magnetic field area are substantially perpendicular to each other.

The present invention provides a thermoelectric power generating device comprising a first wall employed in an experimental nuclear fusion device or a nuclear fusion reactor, and a thermocouple connected to the first wall, wherein electric power is generated based on a difference in temperature caused by the first wall.

The present invention provides, in its fourth aspect, a thermoelectric power generating device comprising:

a first wall employed in a nuclear fusion experimental device or a nuclear fusion reactor,

a member for generating electric power,

an insulating member,

a cooling member,

all of which are mounted on the first wall, and

at least a pair of electrodes mounted along a direction which is substantially perpendicular to both directions of a temperature gradient and a magnetic field, on the member for generating electric power,

wherein the electric power is generated under the Nernst affect based on the temperature gradient and the magnetic field. Preferably the both directions of the temperature gradient and the magnetic field area substantially perpendicular to each other.

With the divertor device according to the present invention, the thermocouple generates electric power based only on the temperature difference without employing any mechanical system. Cooling enhances the temperature difference.

Also, by causing the current to flow through the thermocouple from an external circuit, heat transfer can be achieved by current transporting carriers (usually, electrons). The carriers transfer heat from the surface towards the low-temperature side during plasma experimental. Heat transfer occurs in a reverse direction during baking by causing the current to flow in a reverse direction .

The heat pipe contains an operating liquid in its inside and transfers heat based on heat convection due to a temperature difference, instead of on heat conduction.

Besides, with the divertor device according to the second aspect of the present invention, at least a pair of electrodes are mounted on the power generating member, composed of metal and/or semiconductor, along the direction which is perpendicular to both directions of the temperature gradient and the magnetic field, and an electrical field is induced under the Nernst effect based on the magnetic field and the temperature gradient to enable the voltage to be taken out at the electrodes. Above all, a high voltage output can be taken out using the semiconductor as a power generating member.

In the third aspect of the present invention, the thermocouple is connected not only to the divertor plate which is facing the plasma but also to a first wall which is present in contact with a scrape-off plasma so as to be exposed to a plasma diffused through magnetic lines of force of the scrape-off layer for generating electric power based on the temperature difference produced in the thermocouple. The first wall is subjected to a lesser amount of heat flux produced by a heat load, that is by the plasma radiation, to assure a wider range of application of the thermocouples in general use.

In the fourth aspect of the present invention, at least a pair of electrodes are mounted along a direction which is substantially perpendicular to both directions of the temperature gradient and the magnetic field, on the first wall on the power generating member, formed of metal and/or semiconductor, and an electrical field is induced under the Nernst effect based on the magnetic field and the temperature gradient for enabling a voltage to be taken out at the electrodes. Above all, a high voltage output can be taken out using the semiconductor as a power generating member. Note that carbon is a typical semiconductor which is resistant against heat and radiation,

The meritorious effects of the present invention are summarized as follows:

With the above-described divertor device of the present invention, in which the thermocouple is connected across the divertor plate, and electric power generation is achieved based on the temperature difference on the divertor plate, the thermal energy, which has hitherto been discarded can be converted directly into electrical energy, resulting in an improved divertor plate improved in its efficiency.

Besides, the divertor device according to the present invention, the generating member comprises thermocouples formed of the combination of metals and/or semiconductors. The semiconductor in general produces a higher potential difference than that produced by metal, for the same temperature difference, and thus an increased electrical voltage output per one thermocouple can be obtained.

The divertor device of the present invention has another advantage that heat can be transmitted by convection through a heat pipe arranged within the power generating member to permit efficient heat removal from the divertor.

The divertor device according to the present invention has a further advantage that a higher output voltage, for example, can be taken out by connecting a plurality of thermocouples for divertor plates in series or in parallel with one another.

Besides, with the divertor device of the present invention, an external power source is connected to the thermocouple to supply current thereto to cause carriers to transfer heat. During the plasma experimental operation, the carriers transfer heat from the surface towards the cooled side to contribute to heat removal. Conversely, during baking, current is supplied in an opposite direction to cause heat to be transferred in a reverse direction to cotribute to efficient baking.

Besides, with the divertor device of the present invention, the high-temperature fluid can be caused to flow through the heating pipe which is originally a cooling pipe, while the current can be caused to flow from a power source to the thermocouple, for significantly increasing the baking efficiency.

In the second aspect of the present invention, the electrodes are mounted on the power generating member along a direction which is substantially perpendicular to both directions of the temperature gradient and the magnetic field, and the electric field is induced under the Nernst effect based on the magnetic field and the temperature gradient to enable the voltage to be output from the electrodes. Above all, a high output voltage can be produced under the synergistic effects of the high temperature gradient and the strong magnetic field used for confining the nuclear fusion plasma. Besides, a still higher output voltage can be output using the semiconductor as a power generating member.

In the third aspect of the present invention, a thermocouple is connected not only to the divertor plate, faced by the plasma, but also to the first wall contacted with the scrape-off plasma (peripheral plasma), and electric power is generated based on the temperature difference on the first wall. Above all, the first wall is subjected to a lesser amount of heat load, that is of a heat flux induced by plasma radiation, so that the applicability of the thermocouples can generally be enhanced.

In the fourth aspect of the present invention, at least a pair of electrodes, each composed of metal or semiconductor, are mounted on the first wall on the power generating member in the direction which is perpendicular to both direction of the temperature gradient and the magnetic field, and an electric field is induced under the Nernst effect based on the magnetic field and the temperature gradient to enable an electrical voltage to be output from the electrodes. Above all, a high voltage output can be produced under the synergistic effects of the higher temperature gradient and the strong magnetic field for confinement of the nuclear fusion plasma. In addition, a high voltage output can be produced if the semiconductor is employed as a power generating member.

In the accompanying drawings:

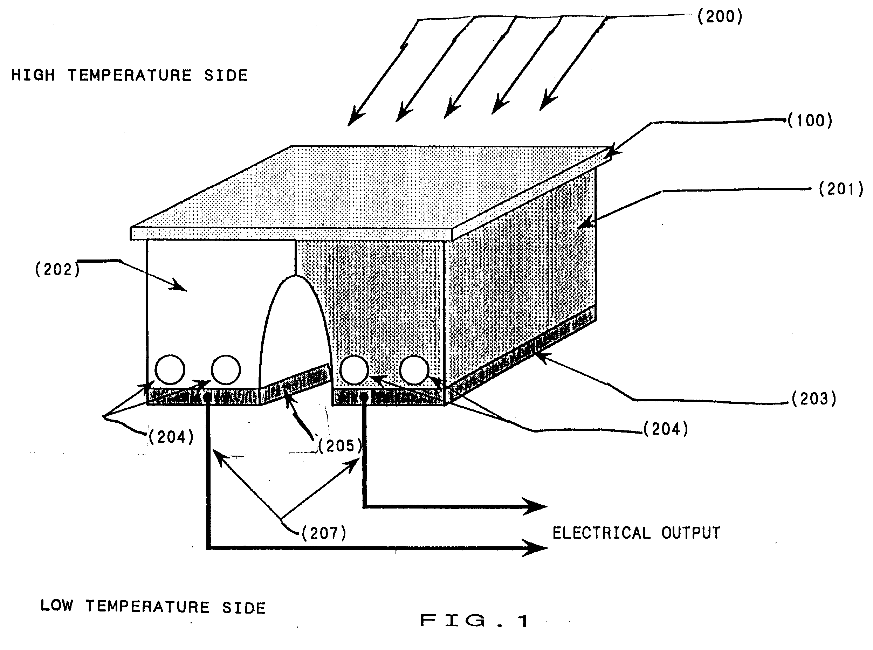

Fig. 1 is a shematic view showing the structure of a first embodiment (for power generation and heat removal) according to the present invention.

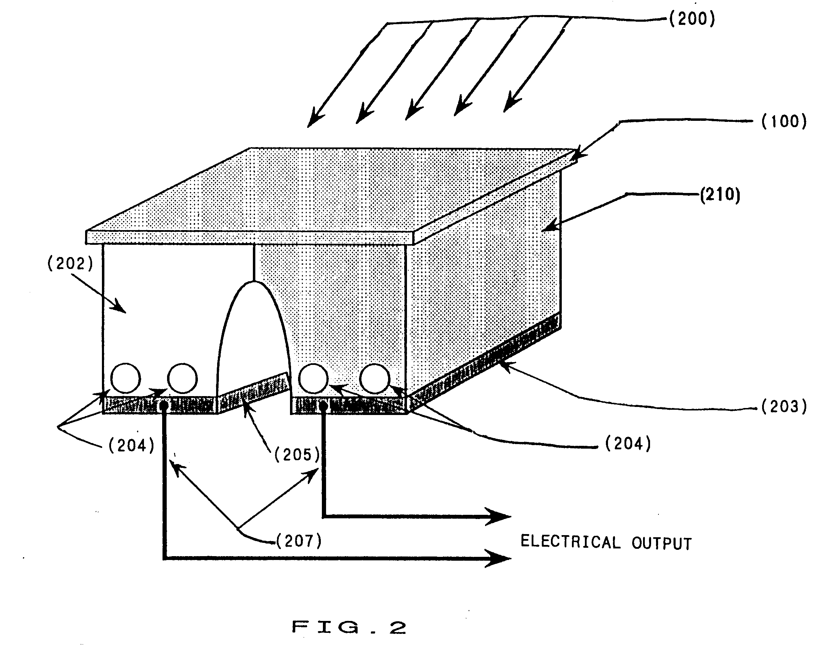

Fig. 2 is a shematic view showing the structure of a second embodiment (for power generation and heat removal) according to the present invention.

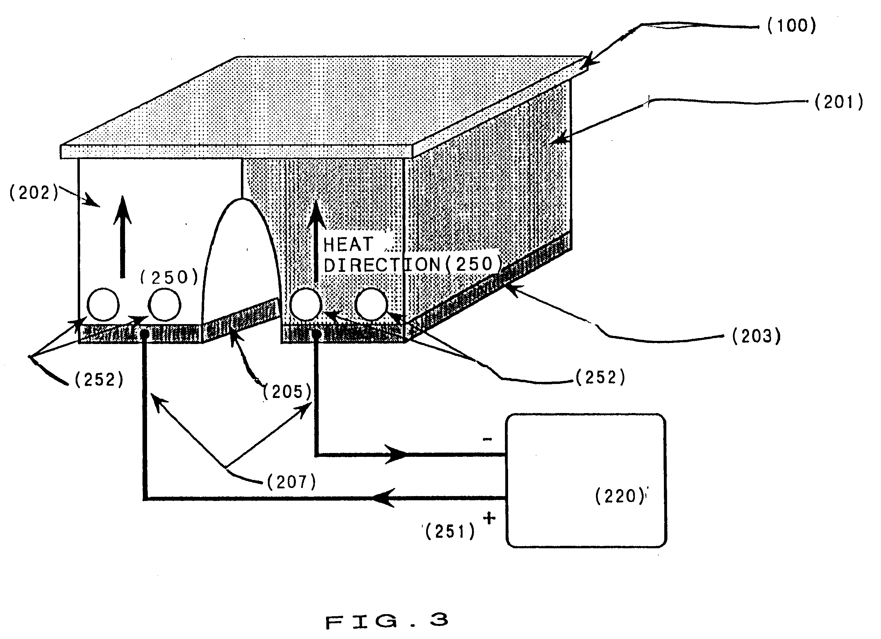

Fig. 3 is a shematic view showing the structure of a third embodiment (for baking) according to the present invention.

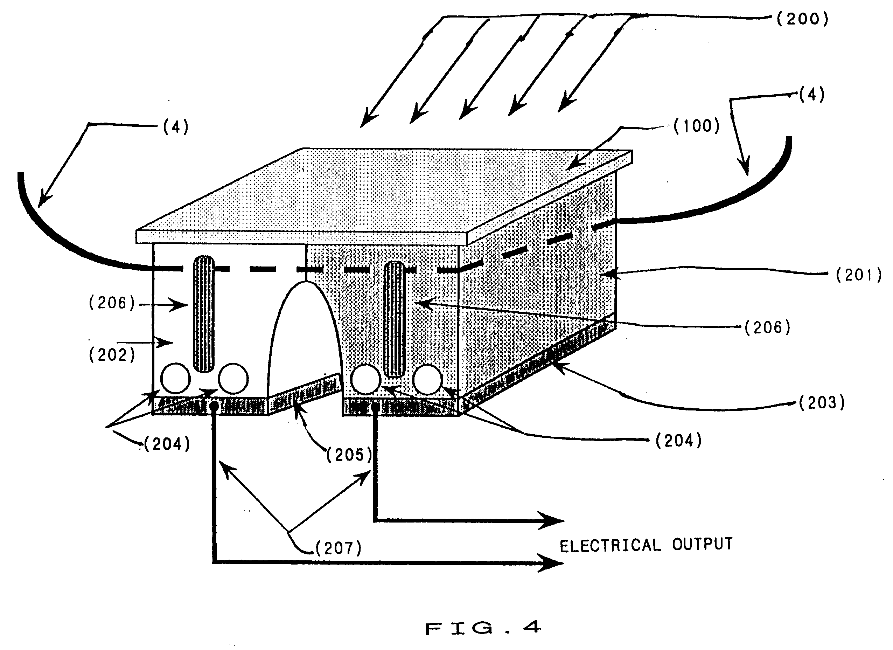

Fig. 4 is a schematic view showing the structure of a fourth embodiment (for power generation and heat removal) according to the present invention.

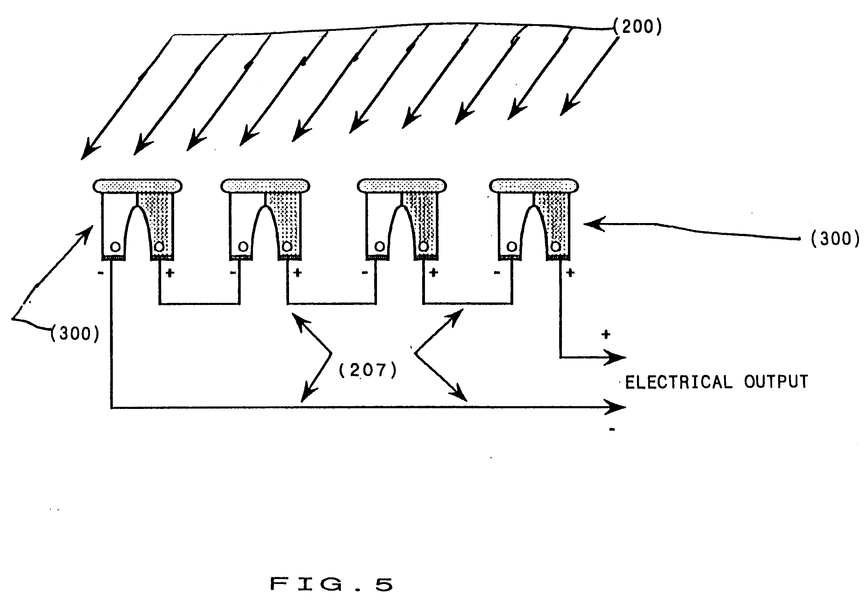

Fig. 5 is a schematic view showing the structure of a fifth embodiment (for power generation and heat removal) according to the present invention.

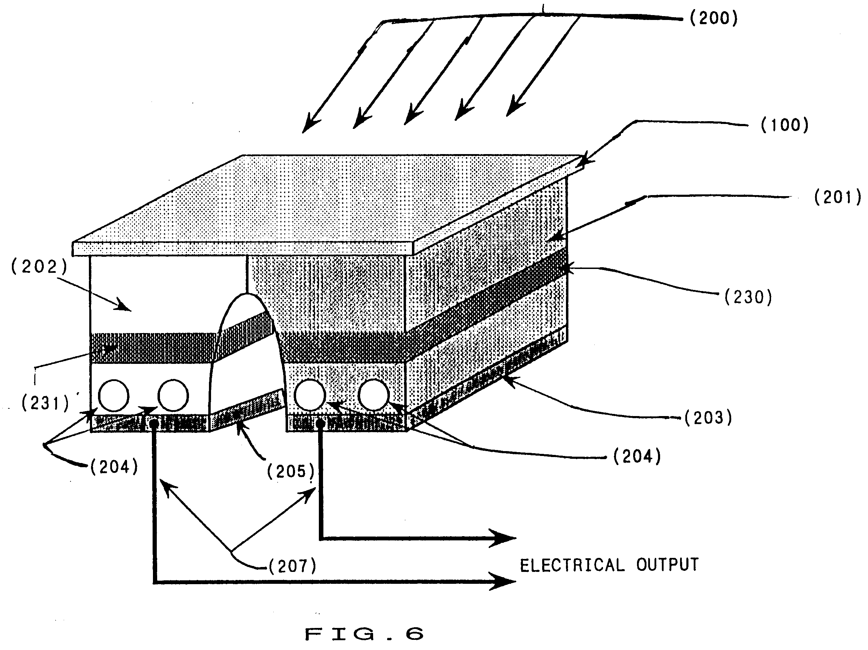

Fig. 6 is a schematic view showing the structure of a sixth embodiment (for power generation and heat removal) according to the present invention.

Fig. 7 is a schematic view of the nuclear fusion testing device known as ITER

Fig. 8 is a cross-sectional view of the conventional nuclear fusion reactor.

Fig. 9 is a schematic view of the conventional divertor plate.

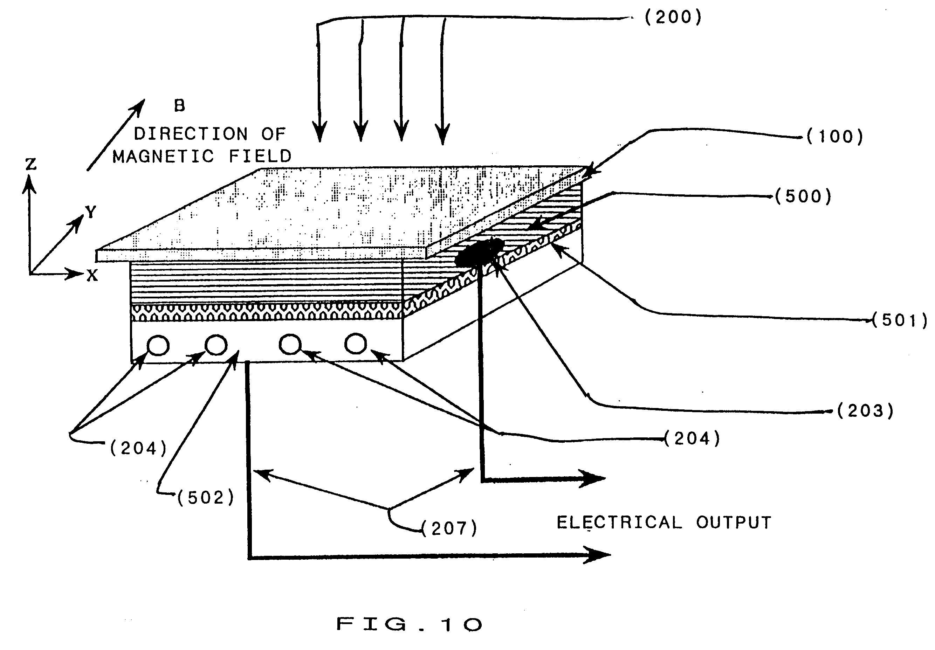

Fig.10 is a shematic view showing the power generating device by a divertor plate by the Nernst effect according to a seventh embodiment of the present invention.

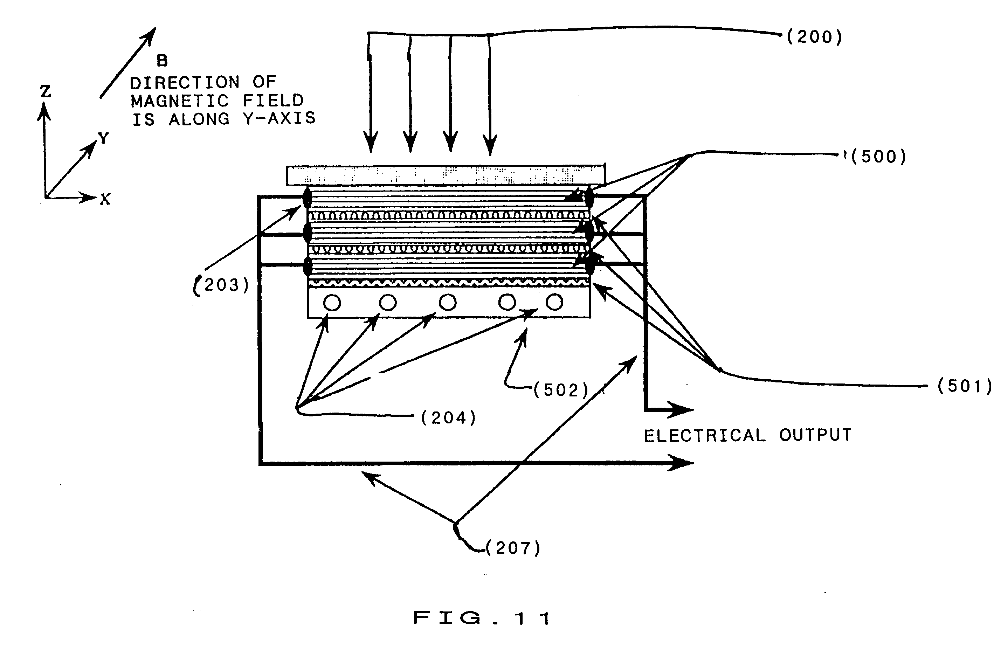

Fig. 11 is a shematic view showing the power generating device by a divertor plate by the Nernst effect according to an eighth embodiment of the present invention.

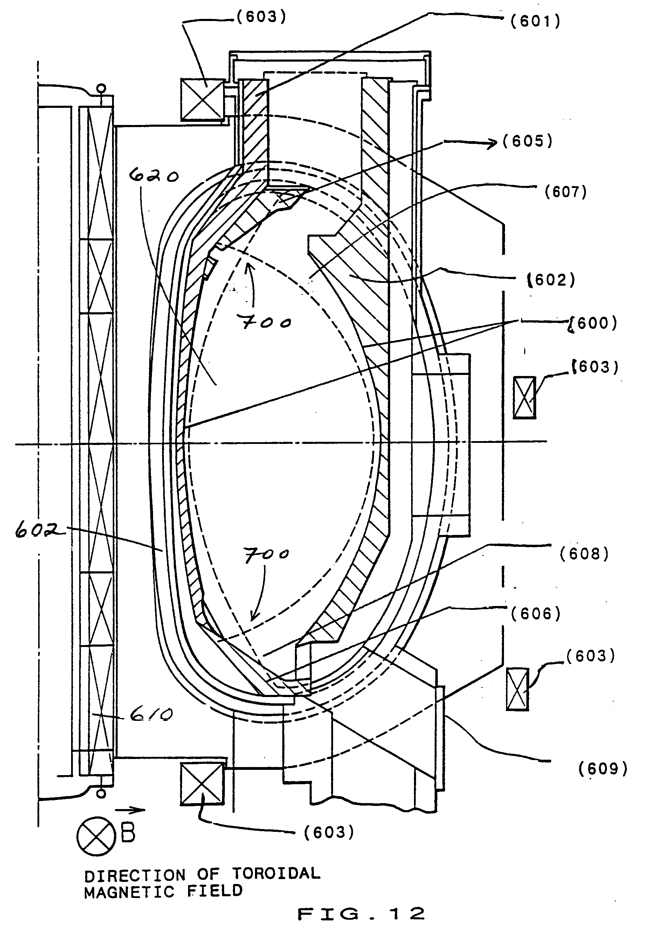

Fig. 12 is a schematic transverse cross-sectional view showing the conventional Tokamak type nuclear fusion reactor.

Referring to the accompanying drawings, certain preferred embodiments of the present invention will be explained in detail.

## First Embodiment

A first embodiment of the present invention will be hereinafter explained by referring to Fig. 1.

In Fig. 1, a flow of particles and radiation 200 from a plasma travels from an upper part of the drawing sheet onto a carbon member 100 forming an upper portion of a divertor plate. A metal member I 201 and a metal member II 202 are arranged on the opposite side of the carbon member 100 with respect to the flow of particles and radiation 200 from the plasma. The high temperature side of the divertor plate (metal members I(201) and II(202)) is electrically connected and the low temperature side is isolated, respectively.

In the present embodiment, cooling pipes 204 are laid in the low temperature side of the divertor. Besides, a positive electrode 203 and a negative electrode 205 are connected to the low temperature side, and a pair of cables 207 are connected to the electrodes and led to an external circuit, not shown. The above arrangement represents a thermocouple device.

## Operation and Result of Embodiment 1

The operation of the present embodiment is hereinafter explained.

The carbon member 100 is heated to a high temperature due to the flow of particles and radiation 200 from the plasma. The temperature exceeds $1000\,^{\circ}C$ for ordinary design. The temperature of the carbon member 100 is set to $T_1$.

On the other side, the low temperature side of the divertor plate is cooled by the cooling pipes 204, which accounts for the appellation "low temperature side". The temperature of the low temperature side is $T_2$. A potential difference represented by the following formula (1):

$$\Delta\Phi = \int_{T_1}^{T_2} S_1(T)dT - \int_{T_1}^{T_2} S_2(T)dT \qquad (1)$$

is produced under the thermoelectric effect.

In the above formula, $S_1(T)$ is the thermoelectric efficiency of the metal member I 201 and $S_2(T)$ is the thermoelectric efficiency of the metal member II 202. The cables 207 are connected to the positive electrode 203 and to the negative electrode 205. It is the sign of the thermoelectric efficiency of each of the two metal members which determines the polarities of the electrodes. Thus the polarities are changed, depending on the manner of combination. The thermocouple output is ultimately used as electrical energy.

Besides, if the thermocouple output is utilized as a power source, current flows and electrons transport heat. If the current flows, the temperature difference is decreased. This is equivalent to the improvement of the heat conductivity to enhance the heat removal.

With the above-described arrangement of the divertor plate, the heat energy, which heretofore was discarded immediately, can be directly transformed into and recovered as electrical energy to improve efficiency of the divertor device.

If electricity is produced to cause an electrical current to flow, such electricity acts for lowering the temperature difference because the electricity transports not only the electric current but also the thermal energy. The result is realization of an efficient heat removal.

Second Embodiment

A second embodiment of the present invention will be explained by referring to Fig. 2.

In Fig. 2, the flow of particles and radiation 200 from the plasma travels from the upper part of the drawing sheet onto the carbon member 100 forming an upper part of the divertor plate to transport heat thereto.

In the present embodiment, the carbon member 210 is used to form a pair with the metal member II 202. The high temperature side and low temperature side of the pair are electrically connected and isolated, respectively. In the present embodiment, a cooling pipe 204 is laid in the low temperature side. A positive electrode 203 and a negative electrode 205 are connected to the low temperature side and connected by calbes 207 to an external circuitry.

Operation and Effect of Embodiment 2

The operation of the present embodiment is hereinafter explained.

The carbon member 100 is heated to a high temperature due to the flow of particles and radiation 200 from the plasma. Under usual design conditions, this temperature, termed $T_1$, exceeds $1000\,°C$. The opposite side is cooled by the cooling pipe 204 and is termed the "low temperature side". This temperature is termed $T_2$. In such case, a potential difference, denoted by the following equation (2), is produced:

$$\Delta\Phi = \int_{T_1}^{T_2} S_c(T)dT - \int_{T_1}^{T_2} S_2(T)dT \qquad (2)$$

In the above equation, $S_c(T)$ is a thermoelectric efficiency of the carbon member 210, while $S_2(T)$ is a thermoelectric efficiency of the metal member II 202. An electric connection is established by the cables 207 across the positive electrode 203 and the negative electrode 205 for utilizing an electrical energy. Heat transfer can be achieved by the current flow, as is the case of employing a metal member, thus leading to effective improvement of heat conductivity.

Meanwhile, the carbon member 210 may be employed as an n-type or p-type semiconductor by doping impurities into the bulk of the carbon member 210.

Carbon is a kind of semiconductors and hence the voltage generated therein for the same temperature difference is higher than that produced in the ordinary metal. Therefore, carbon is suited as a power source member. If a material contacted with the plasma is carbon, both materials are the same material to enable a simpler construction. A higher potential difference can be produced by connecting the n-type semiconductor and the p-type semiconductor to each other. In such case, carbon is the main constituent material.

Embodiment 3

A third embodiment of the present invention is explained by referring to Fig. 3.

Fig. 3 shows a divertor device of the present invention in which there is no plasma as yet. That is, Fig. 3 shows the device at a starting stage of operation.

At this time point, the carbon member 100 needs to be baked because many gaseous substances, including air, are adsorbed thereto. For this reason, the carbon member 100 needs to be heated efficiently. The present third embodiment is directed to high efficiency baking.

As shown in Fig. 3, a power source device 220 is connected to the cables 207 for causing the current to flow through a thermocouple explained in connection with the previous embodiment. A high-temperature fluid is caused to flow through a heating pipe 252.

Operation and Result of Embodiment 3

The result of embodiment is explained as follows.

Under the Seebeck effect, a heat flux $q$ per unit area per unit time is given by the following equation (3):

$$q = x \text{ grad } T + S_1(T)TJ + S_2(T)TJ \qquad (3)$$

In the above equation, $x$ is heat conductivity, $S_1(T)$ a thermoelectric efficiency of metal member I 201, $S_2(T)$ a thermoelectric efficiency of metal member II 202, J current density and T is absolute temperature.

It will be seen from the above equation that the second and third terms of the equation add up to the first term of the equation which stands for usual heat conduction, so that heat can be transported more efficiently to the carbon member 100 than in the case without these two terms.

In the present embodiment, an arrangement for baking is shown, in which the power source device is connected to the cables to cause the current to flow through the thermocouple. Besides, such advantage can be achieved that, by causing a high temperature fluid to flow through the pipe used heretofore for cooling, the thermal energy of the high temperature fluid is transported efficiently to the carbon member 100 under the Seebeck's effect to realize high efficiency baking of the divertor plate.

Embodiment 4

A fourth embodiment of the present invention is explained by referring to Fig. 4.

A flow of particles and radiation 200 from a plasma travels from above onto a carbon member 100 forming an upper portion of a divertor plate to transport the heat thereto. A metal member I 201 and another metal member II 202 are arranged as a pair at the opposite side of the carbon member 100. The high and low temperature sides of the pair are electrically connected and isolated, respectively.

A heat pipe 206 is buried in these metal members. A cooling pipe 204 extends in the low temperature side. A positive electrode 203 and a negative electrode 205 are connected to the metal members, and cables 207, are connected to the electrodes for connection to an external circuitry, not shown.

Besides, in the present embodiment, a thermocouple is constituted so that the wall of a vacuum vessel 4, electrodes of the thermocouple and the cooling pipe 204 are placed outside of the vacuum vessel.

Operation and Effect of Embodiment 4

The operation of the present embodiment is explained.

In the present embodiment, heat is usually transported by heat conduction and under the Seebeck effect explained in connection with the Embodiment 3. The manner of generation of electricity is the same as that explained in connection with the above Embodiment 1. However, since the heat pipe 206 is employed, heat convection, produced within the heat pipe, improves the heat conductivity significantly.

Thus, the heat conductivity is not deteriorated even if the thermocouple is increased in its length. For this reason, the thermocouple can be extended to outside the vacuum vessel 4. Thus there is no necessity to introduce cooling medium used for cooling inside the vacuum vessel.

In the present embodiment, the heat pipe, capable of transporting an amount of heat larger by one digit of magnitude or more than that without the heat pipe, is built in the divertor plate. The present embodiment has such an advantage that, by employing the heat pipe, heat transfer can be achieved by convection instead of any by conduction, such that, by incorporating the heat pipe in the divertor plate, heat removal can be achieved efficiently.

It can be contemplated that, with a semiconductor material, power generation and heat removal are not compatible with each other because the semiconductor material having a high thermoelectric efficiency is generally inferior to metallic material in heat conduction, while it generally lowers the temperature difference and hence is not suited to power generation. In such case, the function of the divertor plate can be fulfilled by the thermocouple and the heat pipe taking charge of generation of electricity and heat removal, respectively.

Embodiment 5

A fifth embodiment of the present invention is explained by referring to Fig. 5.

A flow of particles and radiation 200 is from above towards below in the drawing. A plurality of divertor plates are arranged as shown and electrically connected in series to one another by cables 207. Each divertor plate has a thermocouple described above.

Operation and Result of Embodiment 5

The operation of the present embodiment is explained.

With the present embodiment, since a plurality of divertor plates are connected in series with one another, an increased output voltage of the thermocouples is produced correspondingly.

In a nuclear fusion testing apparatus, hundreds of divertor plates are employed. The divertor plates are expected to become larger in number the larger becomes the size of the experimental nuclear fusion apparatus. On the other hand, the output voltage of the single thermocouple is not so high. Thus, by connecting a plurality of divertor plates in series with one another, an increased output voltage can be obtained and the electrical energy is utilized efficiently while the above-mentioned advantages of the present invention are maintained.

Embodiment 6

A six embodiment of the present invention will be explained by referring to Fig. 6.

The arrangement of the present embodiment is based on the basic arrangement of the first embodiment shown in Fig. 1. However, in the present embodiment, a semiconductor member I 230 and a semiconductor member II 231 are sandwiched between two portions or components of the metal member I 201 and those of the metal member II 202, respectively.

Operation and Result of Embodiment 6

The operation of the present embodiment is explained.

In general, a semiconductor material produces, for the same temperature difference, a higher potential difference which is higher than that achieved with a metallic material. Consequently, with the above-described arrangement, the output voltage generated by each thermocouple becomes higher.

With the present embodiment, the semiconductor members are sandwiched between two metal components making up a thermocouple, with the result that the output voltage of the generated electricity can be improved for the same temperature difference.

Since the semiconductor in general is vulnerable against the radiation, it is necessary to avoid radiation rays from the nuclear fusion reaction. Consequently, a metal component disposed at the side of the divertor plate closer to the plasma is used for shielding the radiation. Although the semiconductor is used in this example, it may be replaced by a component consisting in a combination of the semiconductor and metal.

Embodiment 7

A seventh embodiment of the present invention is explained by referring to Fig. 10.

Fig. 10 illustrates a divertor device embodying the present invention, in which generation of electricity is achieved by taking advantage of a phenomenon known as the Nernst effect. As shown therein, there is a flow of particles and radiation 200 from a plasma, along the direction of a Z-axis, which heats the carbon member 100 of the surface material. When heated, the carbon member 100 transmits heat by heat conduction to a metal member 500 arranged on the lower side in the drawing.

On the opposite side of the carbon member 500 with respect to the flow of plasma particles and radiation 200 an insulating member 501 is placed. A cooling block 502 having cooling pipes 204 in contact with the insulating member 501. A temperature gradient is produced in the Z-axis direction.

For confining a nuclear fusion plasma, a magnetic field, in general, is employed. The direction of the magnetic field is in the Y-axis direction. Since the temperature gradient is produced between the side facing the plasma and the cooled side, the direction of the temperature gradient is in the Z-axis direction. The electric field and the electric voltage, generated by the Nernst effect, are given by the following equation (4) and (5):

$$\vec{E} = N\,\vec{H} \times \text{grad } T \qquad\qquad (4)$$

$$V = \int_{x} \vec{E}\; d\,\vec{x} \qquad\qquad (5)$$

In the above equation (4), N, H and grad T denote the Nernst coefficient, strength of the magnetic field and gradient of temperature, respectively.

In Fig. 10, an electric field is produced in the X-axis direction, with the strength of the electric field being proportional to the temperature gradient and the strength of the magnetic field. The constant N of the Nernst coefficient is a physical quantity of a material and has a predetermined magnitude and a positive or negative sign depending upon the material. A semiconductor member may also be employed, in instead of the metal member, to generate the electricity by the Nernst effect.

The semiconductor material is known in general to be vulnerable against radiations. However, if a semiconductor member is employed in the present embodiment as a member for generating electricity, there is only little problem caused by the effect of radiation on the power generating device, because of the absence of junction plane of the P-N semiconductor. The output voltage of the semiconductor can be high because of a larger magnitude of the constant N of the Nernst effect.

Meanwhile, there is no electric field produced if the temperature gradient is parallel to the direction of the magnetic field. In order for the voltage to be output to outside from the divertor device as an electrical power source, electrodes 203 are placed at both ends of the power generating member 500 in the X-axis. The negative side electrode 205 is not shown. An electrical voltage V is given by integrating the strength of the electric field along the X-axis as indicated by the above equation (5).

The temperature gradient, grad T, defined by design parameters, may be optionally varied for the same material within a predetermined range by changing its cross-sectional area and length.

With the divertor device of the present invention, heat can be removed effectively by the generation of electricity. The Nernst effect is a reversible process, such that, if a high-temperature fluid is caused to flow through a cooling pipe 204, as in the case of thermocouple, and the electric current is supplied from an external power source in the opposite direction, under the magnetic field, the carbon member 100 on the surface of the divertor device can be heated for baking.

Besides, the power generation under the Nernst effect may be used in combination with that by the thermocouple. Since the Nernst coefficient is a function of the temperature, the material of the power generating member may be selected depending on the temperature

Embodiment 8

An eighth embodiment of the present invention is explained by referring to Fig. 11.

A plurality of layers of metal members 500 and insulating members 501 are stacked alternately, as shown in Fig. 11. As may be seen from the above equation (4) showing the Nernst effect, the strength of the electrical field generated is proportional to the temperature gradient. The sum of the voltages taken out from the each layer of the power generating members becomes equivalent to the voltage produced in Embodiment 7, providing a simplified structure.

Although each layer in Fig. 11 is composed of the same metal, an optimum combination using different materials may also be employed, from the view point of the different temperature range in each layer.

Although outputs from the respective layers of the metal member are connected in parallel with one another as shown in Fig. 11, they may also be connected in series with one another.

Embodiment 9

A ninth embodiment of the present invention will be explained by referring to Fig. 12.

Fig. 12 shows the transverse sectional view of a conventional TOKAMAK type experimental nuclear fusion reactor. As shown therein, a scrape-off plasma is present around the core plasma. The plasma in the vicinity of the divertor plate is termed a divertor plasma 608 (see "Peripheral Plasma and Wall Facing it" by S.Takamura, in Researches of Nuclear Fusion, Vol. 68, No. 2, August 1992, page 106).

Referring to Fig. 12, the core plasma 601 is impinged onto divertor plates 605, 606 through x-points 700. The poloidal coil 603 controls the plasma shape and the current, while the center solenoid coil 610 is used for generating the plasma current.

Among the walls exposed to the plasma, there is a first wall, besides the divertor plate. The first wall 600 is arranged so as to be contacted with a scrape-off plasma 607. The rear or backward portions of the first wall 600, as viewed from the plasma, are termed as blankets 601, 602, where heat exchange occurs and also where tritium is breaded by high-energy neutrons from the nuclear reaction with lithium (Li).

Although the first wall 600 is not directly struck by plasma particles, it is exposed to the plasma radiation, so that its surface is heated to an extremely high temperature.

For this reason, in connection with the above-described first embodiment of the divertor device of the present invention, shown in Fig. 1, the first wall 600 substitutes for the carbon member 100 of the divertor plate, the metal member I 201 and the metal member II 202 are joined to the first wall 600 and the electrodes 203, 205 are provided to generate thermoelectricity.

Also, with thermoelectricity generation by the first wall, the above-described third to sixth embodiments are applied in a manner similar to thermoelectricity generation by the divertor plate. A cooling pipe 204 similar to that provided for the divertor plate is provided so that the high-temperature fluid will flow through the cooling pipe, while the current is supplied to the thermocouple from an external power source to control the surface temperature of the first wall 600.

The flow of plasma particles through the first wall 600 is less than that through the divertor plate, such that, in the case of a TOKAMAK reactor, the flow of the scrape-off plasma particles through the first wall is three or more orders of magnitude less than that through the divertor plate.

Consequently, the heat load applied to the first wall, that is the heat flux produced by radiation, is lower than that to the divertor plate, so that the applicability of the thermocouple is generally improved.

On the other hand, the direction of the toroidal magnetic field for confining the plasma generated by the toroidal coil, as indicated by $\vec{B}$, is perpendicular to the surface of the drawing sheet, so that, with the divertor device operated under the Nernst effect based on the temperature gradient and the magnetic field explained in connection with the above-described seventh and eighth embodiments, power generation can similarly be performed by the first wall 600 utilizing the first wall 600 instead of the carbon member 100 of the divertor plate.

It is to be noted that the present invention comprises any combination of the above-described embodiments. On the other hand, although carbon is used in the above-described embodiments as a material to be contacted with the plasma, it may be replaced by some other material. As for the thermoelectric semiconductors, reference is had to chapter 6 "Thermoelectric Semiconductors and Their Application", by K.Kamimura et al, issued by Nikkan Kogyo Shinbunsha, Tokyo in December 1888.

The principle of operation of the thermocouple type power generating device using a semiconductor thermocouple is explained in the below.

An n-type thermoelectric material formed of n-type semiconductor and a p-type thermoelectric material formed of p-type semiconductor are directly or indirectly jointed at one end, for example via a connecting (metal) member(1) (as an electrically conductive member) and electrode members(2) ( + ,-) are attached to both n-type and p-type thermoelectric materials with the other ends to form a II-shaped configuration e.g., as shown in Fig. 1. The connecting (metal) member (1) at one side (joint side of the II-shape) is heated by a plasma to an elevated temperature while the electrode members (2) ( + ,-) disposed at an opposite side (leg ends of the II-shape) are cooled. The heat supplied to the n-type and p-type thermoelectric materials via the connecting (metal) member (1) is transferrd to the electrode members (2) ( + ,-) at the other ends, and removed to establish a temperature difference between the connecting (metal) member (1) and the electrode members (2) ( + ,-) along the direction of heat flow. An output voltage is obtained via a voltage produced due to the temperature difference. Preferably, to remove the heat from said other ends, a cooling system is used in association with the thermocouple.

The connecting (metal) member (1) may be a part of the divertor plate or wall which may be a heat and radiation resistant material stable against plasma such as carbon, boron carbide or the like. The material for the thermocouple may be a combination of carbon and boron carbide in view of the stability and efficiency. If metal is used as a wall material, the metal is covered with a heat resistant material such as carbon etc.

It is preferred to use a cooling system to establish a sufficient temperature difference between the two members (1) and (2). The cooling (pipe) system is disposed close to the electrode members (2) and it is preferred to utilize the cooling system for the wall system (divertor plate or the first wall etc.).

The thermocouple may be disposed within a wall plate or attached to the wall plate so as to establish a temperature difference in the thermocouple itself. The connecting member (1) is disposed at a position of high temperature, and a high temperature difference is obtained, while the difference is enhanced by applying a cooling system at a low temperature side in association with the thermocouple.

In case with the II-shaped configuration like Fig. 1 provided that a pair (p,n) of semiconductor members are used in place of the metal members I(201) and II(202), both the semiconductor members (201,202) are preferably disposed without direct contact each other. However, if a more conductive material (e.g., metal) is used in place of the carbon member (100), partial contact between the two semiconductor members (201,202) in the vicinity of the connecting member (1) would provide little adverse influence.

It should be noted that modification apparent in the art can be done without departing from the gist and scope of the present invention as disclosed and claimed as appended.

## Claims

1. A divertor device for generating electric power comprising a divertor plate employed in an experimental nuclear fusion device or a nuclear fusion reactor and a thermocouple disposed in contact with said divertor plate, wherein the electric power is generated based on a difference in temperature caused by said divertor plate.

2. The divertor device as defined in claim 1 which further comrises a cooling system for giving a high temperature difference to said thermocouple.

3. The divertor device as defined in claim 1 or 2 wherein said thermocouple for generating electric power based on the difference in temperature is formed of metal, semiconductor or a combination of metal and semiconductor.

4. The divertor device as defined in claim 1, 2 or 3 wherein a heat pipe is built in said thermocouple for generating electric power based on the difference in temperature.

5. The divertor device as defined in any one of claims 1 to 4 wherein thermocouples are disposed to a plurality of the divertor plates and are connected in series or in parallel each other.

6. The divertor device as defined in any one of claims 1 to 5 wherein electric current is supplied to said thermocouple from an external power source connected to said thermocouple.

7. The divertor device as defined in any of claims 1 to 6 which comprises a cooling pipe through which a high temperature fluid is caused to flow for baking said divertor plate and electric current is supplied to said thermocouple from an external power source for controlling surface temperature of the divertor plate.

**8.** A divertor device comprising :

a divertor plate employed in an experimental nuclear fusion device or a nuclear fusion reactor,

a member for generating electric power,

an insulating member,

a cooling member,

said member for generating electric power, the insulating member and the cooling member being mounted to said divertor plate,

and at least a pair of electrodes mounted on said member for generating electric power along a direction which is perpendicular to both directions of a temperature gradient and a magnetic field,

wherein the electric power is generated under the Nernst effect based on the temperature gradient and the magnetic field.

**9.** The divertor device as defined in claim 8 which further comprises a thermocouple mounted to said divertor plate, such that the electric power is generated under the Nernst effect and further based on a difference in temperature caused by said divertor plate.

**10.** The divertor device as defined in claim 8 or 9 wherein said member for generating electric power is formed of metal and/or semiconductor.

**11.** The divertor device as defined in claim 8, 9 or 10 wherein said member for generating electric power and the insulating member are alternately stacked in a plurality of layers.

**12.** The divertor device as defined in any one of claims 8 to 11 wherein said cooling member comprises a cooling pipe through which a high temperature fluid is caused to flow for baking said divertor plate, and electric current is supplied to said electrodes from an external power source for controlling surface temperature of the divertor plate.

**13.** A thermoelectric power generating device comprising a first wall employed in an experimental nuclear fusion device or a nuclear fusion reactor and a thermocouple disposed in contact with said first wall, wherein electric power is generated based on a difference in temperature caused by said first wall.

**14.** The thermoelectric power generating device as defined in claim 13 wherein said thermocouple is formed of metal and/or semiconductor.

**15.** The thermoelectric power generating device as defined in claim 13 or 14 wherein a heat pipe is built in a member for generating electric power based on the difference in temperature.

**16.** The thermoelectric power generating device as defined in any one of claims 13 to 15 wherein thermocouples are disposed in contact with said first will and connected in series or in parallel each other.

**17.** The thermoelectric power generating device as defined in any one of claims 13 to 16 wherein electric currant is supplied to said thermocouple from an external power source connected to the thermocouple.

**18.** The thermoelectric power generating device as defined in any one of claims 13 to 17 wherein said first wall comprises a cooling pipe through which a high temperature fluid is caused to flow for baking said first wall.

**19.** The thermoelectric power generating device as defined in claim 18 wherein the electric current is supplied to said thermocouple from said external power source for controlling surface temperature of the first wall.

**20.** A thermoelectric power generating device comprising:

a first wall employed in an experimental nuclear fusion device or a nuclear fusion reactor,

a member for generating electric power,

an insulating member,

a cooling member,

said member for generating electric power, the insulating member and the cooling member being mounted to said first wall, and

at least a pair of electrodes mounted on said member for generating electric power along a direction, which is substantially perpendicular to both directions of a temperature gradient and a magnetic field, preferably said both directions being also substantially perpendicular to each other,

wherein electric power is generated under the Nernst effect based on the temperature gradient and the magnetic field.

21. A thermoelectric power generating device comprising

a wall exposed to a plasma from a nuclear fusion experimental device or a nuclear fusion reactor and

a thermocouple disposed in contact with said wall, wherein electrical power is generated based on a difference in temperature caused by said wall.

22. A thermoelectric power generating device comprising:

a wall exposed to a plasma generated in an experimental nuclear fusion device or a nuclear fusion reactor,

a member for generating electric power,

an insulating member,

a cooling member,

said member for generating electric power, the insulating member and the cooling member being mounted to said first wall, and

at least a pair of electrodes mounted on said member for generating the electric power along a direction which is substantially perpendicular to both directions of a temperature gradient and a magnetic field, wherein electric power is generated under the Nernst effect based on the temperature gradient and the magnetic field, preferably said both directions also being perpendicular to each other.

23. A method for generating electric power comprising:

providing a thermocouple disposed in association with a wall to be exposed to a plasma in an experimental nuclear fusion device or a nuclear fusion reactor, and

generating elecric power based on a difference in temperature caused by said wall.

24. A method as defined in claim 23 , wherein the difference in temperature is enhanced by cooling.

25. A method as defined in claim 23 or 24, wherein a heat pipe is further used in association with said thermocouple.

26. A method for baking a wall to be exposed to a plasma for use in an experimental nuclear fusion device or a nuclear fusion reactor, comprising:

providing a thermocouple disposed in association with the wall, and

supplying electric currant to the thermocouple to provide heat to said wall for baking.

27. A method as defined in claim 26 wherein as the thermocouple, a thermocouple disposed for generating electric power based on a temperature difference caused by the will is used and the electric current is supplied from an external power source.

28. A method as defined in claim 26 or 27, wherein a high temperature fluid is caused to flow through a cooling pipe disposed in association with said wall.

29. A method as defined in claim 26, 27 or 28 wherein a heat pipe is further used for transferring heat in association with said thermocouple.

30. A method for generating electric power comprising:

providing a member for generating electric power in association with a wall to be exposed to a plasma along a direction which is substantially perpendicular to both directions of a temperature gradient and a magnetic field, and

generating electric power under the Nernst effect based on the temperature gradient and the magnetic field.

31. A method as defined in claim 30, wherein said member for generating electric power is formed of metal, semiconductor or a combination thereof.

32. A method as defined in claim 30 or 31 wherein said wall comprises a divertor plate and/or a first wall of an experimental nuclear fusion device or a nuclear fusion reactor.

33. A method as defined in claim 30, 31 or 32 which further comprises:
       providing a thermocouple in association with said wall along a direction of temperature difference,
       generating electric power based on the temperature difference caused by said wall.

34. A method as defined in claim 33 wherein a heat pipe is used in association with said thermoucouple.

35. A method as defined in any one of claims 30 to 34 wherein cooling is carried out to enhance the temperature gradient with respect to said member for generating electric power.

36. A method as defined in claim 33, 34 or 35 wherein cooling is carried out to enhance the temperature difference with respect to said thermocouple.

HIGH TEMPERATURE SIDE

(200)

(100)

(201)

(202)

(203)

(204)

(204)

(205)

(207)

ELECTRICAL OUTPUT

LOW TEMPERATURE SIDE

FIG. 1

EP 0 603 913 A1

17

FIG. 2

FIG. 3

FIG. 4

(200)

(300)

(300)

(207)

+

ELECTRICAL OUTPUT

−

FIG.5

EP 0 603 913 A1

FIG.6

EP 0 603 913 A1

FIG. 7

(4)

(2)

(52)

(50)

CORE PLASMA
(D+Tritium+He)

RADIATIONS

STRONG MAGNETIC FIELD

VACUUM
EXHAUST
DEVICE
(51)

~10²Pa

~1 ATM.

(5)

(53)

FIG.8

FIG.9

B
DIRECTION OF
MAGNETIC FIELD

(200)

(100)

(500)

(501)

(203)

(204)

(204)

(502)

(207)

ELECTRICAL OUTPUT

FIG.10

EP 0 603 913 A1

B
DIRECTION OF
MAGNETIC FIELD
IS ALONG Y-AXIS

Z

Y

X

(200)

(500)

(203)

(501)

(502)

(204)

ELECTRICAL OUTPUT

(207)

FIG. 11

EP 0 603 913 A1

DIRECTION OF TOROIDAL
MAGNETIC FIELD

FIG. 12

28

## DOCUMENTS CONSIDERED TO BE RELEVANT

| Category | Citation of document with indication, where appropriate, of relevant passages | Relevant to claim | CLASSIFICATION OF THE APPLICATION (Int.Cl.5) |
|---|---|---|---|
| A | BE-A-626 013 (WESTINGHOUSE)<br><br>* page 1, last paragraph *<br>* page 3, last paragraph *<br>* page 5, paragraph 2-3 *<br>* page 6, last paragraph - page 7, paragraph 1 *<br>* page 13, last paragraph - page 15, paragraph 1 *<br>--- | 1,3,5,9, 10,13, 14,16, 21,23, 31,33 | G21B1/00<br>H05H1/12 |
| A | FUSION ENGINEERING AND DESIGN<br>vol. 9 , 1989 , AMSTERDAM NL<br>pages 451 - 455<br>INUI ET AL. 'Preliminary study of the performance characteristics of a MHD generator for the Compact Fusion Advanced Rankine Cycle'<br>* page 455, paragraph 4.3 *<br>--- | 1,13 | |
| A | NUCLEAR TECHNOLOGY FUSION<br>vol. 4, no. 3 , November 1983 , LA GRANGE PARK, ILLINOIS US<br>pages 479 - 490<br>SCHWERTZ ET AL. 'A Heat Pipe concept for cooling a liquid-pool blanket of a tandem mirror fusion reactor'<br>* abstract *<br>--- | 4,15,25, 29 | TECHNICAL FIELDS SEARCHED (Int.Cl.5)<br><br>G21B<br>H05H<br>G21H |
| A | DATABASE WPI<br>Week 8538,<br>Derwent Publications Ltd., London, GB;<br>AN 85-233263 [38]<br>& JP-A-60 151 582 (I.H. JUKO) 9 August 1985<br>* abstract *<br>---<br>-/-- | 1-3,23, 24,35,36 | |

The present search report has been drawn up for all claims

| Place of search | Date of completion of the search | Examiner |
|---|---|---|
| THE HAGUE | 31 March 1994 | Capostagno, E |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## DOCUMENTS CONSIDERED TO BE RELEVANT

| Category | Citation of document with indication, where appropriate, of relevant passages | Relevant to claim | CLASSIFICATION OF THE APPLICATION (Int.Cl.5) |
|---|---|---|---|
| A | PROCEEDINGS OF THE 14TH SYMPOSIUM ON FUSION TECHNOLOGY - AVIGNON, FRANCE 8/12 SEPT. 1986 vol. 1 pages 431 - 434 LIPA ET AL. 'First-wall design for TORE SUPRA' * page 433, paragraph 5.1 - page 434, paragraph 5.3 * | 7,12,18, 26 | |
| A | PROCEEDINGS OF THE 14TH IEEE/NPSS SYMPOSIUM ON FUSION ENGINEERING - SAN DIEGO, CA. - 30 SEPT./3 OCT. 1991 vol. 1 pages 31 - 36 XP308346 LABOMBARD ET AL. 'Design of limiter/divertor first-wall components for ALCATOR C-MOD' * the whole document * | 1,8, 20-22,32 | |
| A | PROCEEDINGS OF THE 20TH INTERSOCIETY ENERGY CONVERSION ENGINEERING CONFERENCE vol. 3 , August 1985 , SAE P-164 pages 542 - 550 A. LINDSAY CARROLL 'High temperature stage of cascaded rtg' | | TECHNICAL FIELDS SEARCHED (Int.Cl.5) |

The present search report has been drawn up for all claims

| Place of search | Date of completion of the search | Examiner |
|---|---|---|
| THE HAGUE | 31 March 1994 | Capostagno, E |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

                              

& : member of the same patent family, corresponding
    document